(19) Europäisches Patentamt
European Patent Office
Office européen des brevets

(11) EP 2 718 066 B1

(12) FASCICULE DE BREVET EUROPEEN

(45) Date de publication et mention de la délivrance du brevet:
**16.03.2016 Bulletin 2016/11**

(51) Int Cl.:
**B25J 15/02** *(2006.01)*   **B25J 7/00** *(2006.01)*

(21) Numéro de dépôt: **12728643.3**

(22) Date de dépôt: **24.05.2012**

(86) Numéro de dépôt international:
**PCT/FR2012/000208**

(87) Numéro de publication internationale:
**WO 2012/168568 (13.12.2012 Gazette 2012/50)**

(54) **OUTIL POUR PINCE MICROTECHNIQUE**

WERKZEUG FÜR EINE MIKROTECHNISCHE KLAMMER

TOOL FOR A MICROTECHNICAL CLIP

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.06.2011 FR 1101715**

(43) Date de publication de la demande:
**16.04.2014 Bulletin 2014/16**

(73) Titulaires:
• **Centre National de la Recherche Scientifique (CNRS)**
**75794 Paris Cedex 16 (FR)**
• **Universite De Franche-Comte (Etablissement Public)**
**25030 Besancon (FR)**

(72) Inventeurs:
• **HERIBAN, David**
**F-25480 Ecole Valentin (FR)**
• **AGNUS, Joël**
**F-25870 Auxon dessous (FR)**

(74) Mandataire: **Cabinet Netter**
**36, avenue Hoche**
**75008 Paris (FR)**

(56) Documents cités:
DE-C1- 10 114 551   US-A- 5 046 773
US-A- 5 332 275

**Description**

La présente invention se rapporte à un outil pour pince microtechnique comprenant un embout ainsi qu'à une pince microtechnique et son procédé de montage comprenant un tel outil.

Les micro- et nanotechnologies évoluent rapidement. Ces technologies mettent en oeuvre des fabrications et des procédés à l'échelle submillimétrique, à savoir dans le domaine du micromètre et nanomètre.

Les applications des micro- et nanotechnologies sont vastes et sont notamment utilisés pour le micro-usinage lors de la fabrication de microsystèmes (puces électroniques de type capteur/actionneur) ou microsystèmes/nanosystèmes électromécaniques (MEMS : *« microelectromecanicalsystems »*, MST : *« microsystemtechnology »* ou NST : *« nanosystemtechnology »*).

Les systèmes précités trouvent leur application dans différents domaines parmi lesquels on peut citer l'industrie automobile, l'aéronautique, la télécommunication, la biotechnologie, la médecine, la physique, l'informatique, l'électronique, l'ingénierie moléculaire ou encore l'ingénierie de nanomatériaux.

Le domaine de la mécatronique, qui combine l'électronique, la mécanique et l'informatique pour commander des systèmes complexes, utilise également des systèmes micro- ou nanotechnologiques.

Les appareillages en micro- ou nanotechnologies utilisent classiquement des matériaux de type piézoélectrique, silicium ou analogue. Les phénomènes physiques mis en oeuvre se basent essentiellement sur les propriétés thermiques, capacitives, magnétiques, piézoélectriques, électrostatiques ou analogues des matériaux utilisés. C'est la nature même du matériau et de ses propriétés physiques qui permet de réaliser des systèmes compacts générant des mouvements de haute résolution (1 nm à 1 $\mu$m).

Comme indiqué, ces technologies opèrent à l'échelle du micro- ou nanomètre et doivent relever d'une grande précision. Ceci est d'autant plus vrai lorsqu'il s'agit de manipuler des objets ou d'assembler des pièces miniaturisées.

Dans le domaine du micro- ou nano-assemblage, il faut prévoir des dispositifs capables d'opérer au micromètre ou nanomètre près. On connaît aujourd'hui des micro-actionneurs de type micro-pinces qui permettent de manipuler les objets ou pièces de très petite taille. Les micro-pinces comprennent de manière générale deux pièces mécaniques déformables. Ces pièces mécaniques déformables sont communément appelées branches. Les extrémités des branches sont agencées de manière à permettre un rapprochement et/ou un éloignement les unes des autres.

Le rapprochement des extrémités respectives de deux branches voisines permet d'assurer la préhension d'objets ou de pièces microscopiques par serrage mécanique. Ces branches sont généralement constituées de matériaux actifs, c'est-à-dire sensibles à une excitation de type électrique, magnétique, ou thermique notamment. Cette excitation entraîne la déformation des branches, donc un déplacement de leurs extrémités, et donc la fermeture ou l'ouverture de la micro-pince.

Les micro-pinces peuvent être fabriquées d'un seul tenant, à savoir de façon monolithique. On parle alors classiquement de « micro-pinces monolithiques ».

Les micro-pinces peuvent aussi être composées de plusieurs éléments distincts. On parle alors classiquement de « micro-pinces assemblées ».

Lorsqu'une pince est réalisée de façon monolithique, une extrémité de branche est généralement formée par la partie terminale de ladite branche déformable. En conséquence, la détérioration des de cette partie terminale (extrémité) va de paire avec la détérioration d'une partie des branches et ainsi de la micro-pince.

Les micro-pinces monolithiques de l'état de la technique sont généralement limitées en distance de course, qui dépasse rarement 100 $\mu$m. Cette technologie fournit une échelle de précision de manipulation assez sensible allant d'environ 0,1 $\mu$m à 1 $\mu$m.

Parmi les micro-pinces assemblées on peut citer celles comprenant un embout sur chaque partie terminale de branche. C'est donc l'embout qui forme l'extrémité d'une branche déformable. En conséquence, dans ce type de micropinces, ce sont les embouts qui entrent en contact avec les objets ou pièces à manipuler. Ces embouts, souvent de taille microscopique en regard des objets manipulés, sont fragiles et soumis à des contraintes mécaniques, lesquelles peuvent causer leur détérioration, voire leur destruction.

Les embouts peuvent être formés par des éléments indépendants conçus pour être fixés sur chaque branche, de façon définitive ou non. Il s'agit par exemple, pour une micro-pince à serrage symétrique pourvue de deux branches, d'une paire symétrique d'embouts, chaque embout étant prévu pour être respectivement fixé sur chaque branche.

Un avantage des micro-pinces assemblées est que la détérioration d'un embout (extrémité) n'entraîne pas nécessairement la détérioration de la branche correspondante.

Mais le positionnement de ces embouts sur les branches peut s'avérer problématique, long et imprécis. En effet, généralement un embout est collé manuellement sur la partie terminale d'une branche. Ceci peut entrainer des embouts qui ne sont pas disposé en une orientation initialement prévue. Le positionnement relatif de deux embouts voisins est donc variable et dépendant des manipulations de l'opérateur. La précision requise pour les systèmes microou nanotechnologiques n'est donc pas garantie (10 $\mu$m de précision dans le meilleur des cas). Le temps d'assemblage est long (plus de 30 minutes par pince) et la fragilité des embouts et/ou des branches de la pince est souvent incompatible avec un montage manuel.

Il existe des dispositifs robotiques pour disposer des embouts sur les branches. Le positionnement est plus fiable et plus précis mais requiert des procédés de fabrications et d'assemblage couteux et longs à mettre en oeuvre. La fragilité des embouts nécessite un changement fréquent, et les dispositifs robotiques nécessaires doivent être à disposition.

Les micro-pinces assemblées de l'état de la technique sont généralement limitées en précision. Cette technologie fournit une échelle de précision de manipulation allant d'environ 10 μm à 100 μm.

Les échelles de précision de manipulation entre les différentes technologies de micro-pinces (monolithiques ou assemblées) sont différentes. On peut en effet constater un « vide » pour une échelle de précision de manipulation allant d'environ 1 μm à 10 μm qui se retrouve de même pour les courses d'ouverture de pince.

Le document US 2006/0181097 A1 divulgue une micro-pince monolithique pour le serrage d'objet. La déformation des branches est réalisée par une contrainte mécanique externe.

Le document US 4,666,198 divulgue une micro-pince monolithique comprenant une paire de branches réalisées en un matériau polymère piézoélectrique.

Le document US 5,046,773 divulgue une micro-pince assemblée comprenant une paire de branches combinée à un vérin pneumatique. Les embouts sont assemblés aux branches par une liaison mécanique par des vis.

Le document WO 2004/028756 divulgue une micro-pince à branches piézoélectriques équipée d'électrodes.

Le document DE 101 14 551 divulgue une micro-pince comprenant un micro-actionneur linéaire et un embout comportant un support et deux doigts, chaque doigt étant relié audit support par un élément de liaison respectif souple agencé de manière à maintenir le doigt en une position de repos correspondant à sa position initiale. Aucun des dispositifs décrits dans les documents de l'état de la technique ne comble les déficiences citées ci-dessus.

L'invention vient améliorer la situation.

À cet effet l'invention vient introduire un outil pour pince microtechnique, comprenant un embout comportant un support et un premier doigt et un deuxième doigt, chaque doigt possédant un socle de fixation par lequel il est destiné à être fixé sur une branche de micro-actionneur pour positionner les doigts côte à côte en des positions initiales respectives, définies par rapport à au moins une direction d'actionnement des branches de la pince microtechnique, chaque doigt étant relié audit support par un élément de liaison respectif souple agencé de manière à maintenir le doigt en une position de repos correspondant à sa position initiale, cet élément de liaison étant choisi avec des caractéristiques de raideur, définissant un compromis entre le besoin de limiter la flexion de l'élément de liaison sous le poids du doigt associé quelle que soit l'orientation du doigt dans l'espace, et la nécessité d'autoriser la mobilité du doigt concerné par rapport au support selon la ou les directions d'actionnement desdites branches de la pince microtechnique.

Selon un mode de réalisation, l'élément de liaison présente une grande dimension qui s'étend sensiblement dans le prolongement du doigt respectif et les caractéristiques de raideur sont définies par rapport à une direction généralement transversale à ladite grande dimension. Chaque doigt peut comprendre une griffe disposée en extrémité distale par rapport au support.

L"élément de liaison peut être réalisé en résine photosensible de type SU-8.

L'embout peut être réalisé monolithiquement. L'élément de liaison peut notamment comprendre une structure ressort.

L'outil de l'invention peut comprendre en outre au moins un capteur disposé sur au moins un desdits doigts. De préférence, le capteur est choisi parmi le groupe constitué d'un capteur d'effort, d'un capteur de température, d'un capteur de pression, d'un capteur d'hygrométrie et d'un capteur de contact.

L'outil de l'invention peut aussi comprendre en outre une plaque de transmission reliée électriquement sur le support de l'embout.

L'invention vise également une pince microtechnique comprenant un outil selon l'invention et un micro-actionneur comprenant de première et deuxième branches déplaçables, chaque branche étant solidarisée par un socle de fixation respectivement avec le premier doigt et le deuxième doigt.

Dans un mode de réalisation particulier, la pince microtechnique de l'invention comprend un réceptacle qui loge les branches déplaçables, le réceptacle étant conformé sensiblement en U et comprenant deux parois extérieures marquées chacune par une encoche conformée pour recevoir ledit support de l'embout.

Chaque doigt dudit embout peut être muni d'un capteur dont les bornes électriques sont disposées sur le support. Une plaque de transmission de signaux peut comprendre des connexions électriques qui sont disposées en contact avec ledit support pour relier électriquement lesdites bornes électriques avec lesdites connexions électriques.

De préférence le micro-actionneur de la pince est choisi parmi le groupe constitué d'un micro-actionneur thermique, d'un micro-actionneur piézo-électrique et d'un micro-actionneur électrostatique.

L'invention vise également un kit microtechnique pour le montage d'une pince microtechnique comprenant. Le Kit de l'invention comprend un outil pour pince microtechnique selon l'invention, un micro-actionneur comprenant de première et deuxième branches déplaçables, un réceptacle conformé sensiblement en U et comprenant deux parois extérieures chacune marquées par une encoche conformée pour recevoir ledit support de l'embout de l'outil pour pince microtechnique.

Le kit de l'invention, peut comprendre un capteur disposé sur au moins un des doigts de l'embout dont les bornes électriques sont disposées sur ledit support. Dans ce cas, le kit comprend en outre une plaque de transmission de signaux comprenant des connexions électriques, agencée pour être disposée en contact avec ledit support pour relier électriquement lesdites bornes électriques avec lesdites connexions électriques.

L'invention vise aussi un procédé de montage d'une pince microtechnique comprenant les étapes suivantes

a. préparer un outil pour pince microtechnique selon l'invention,

b. préparer un micro-actionneur comprenant de première et deuxième branches déplaçables, et

c. solidariser par un socle de fixation les premier et deuxième doigts de l'embout pour pince microtechnique respectivement avec les première et deuxième poutres du micro-actionneur pour former ladite pince microtechnique.

Le Procédé peut comprendre en outre l'étape suivante :

b1. Déplacer lesdites première et deuxième poutres du micro-actionneur en une position choisie avant de solidariser à l'étape c.

Le Procédé peut comprendre en outre l'étape suivante :

b2. manipuler chaque doigt par application d'une force de manière à modifier leur position de repos avant de solidariser à l'étape c.

Le Procédé peut comprendre en outre l'étape suivante :

d. loger lesdits premier et deuxième doigts et lesdites première et deuxième poutres dans un réceptacle conformé sensiblement en U et comprenant deux parois extérieures marquées par au moins une encoche conformée pour recevoir le support de l'embout de l'outil pour pince microtechnique, et

e. positionner ledit support dans chaque encoche.

D'autres avantages et caractéristiques de l'invention apparaîtront à la lecture de la description détaillée ci-après et sur les dessins annexés sur lesquels :

- la figure 1 représente une vue schématique en perspective d'un embout de l'outil pour pince microtechnique selon un mode de réalisation de l'invention ;

- la figure 2 représente une vue schématique de dessus de l'embout de la figure 1 monté sur un micro-actionneur ;

- la figure 3 représente une vue en perspective d'un élément de liaison en position de déplacement d'un embout selon un mode de réalisation de l'invention ;

- la figure 4 représente une vue en perspective de l'élément de liaison de la figure 3 dans une autre position de déplacement;

- la figure 5 représente une vue éclatée en perspective d'une pince microtechnique selon un mode de réalisation de l'invention ;

- la figure 6 représente une vue en perspective de la pince microtechnique de l'invention partiellement assemblée;

- la figure 7 représente une vue en perspective de la pince microtechnique de l'invention partiellement assemblée et comprenant un capteur d'effort ;

- la figure 8 représente une vue en perspective d'un embout comprenant un capteur d'effort assemblé avec une plaque de transmission ;

- la figure 9 est un organigramme d'un procédé de montage d'une micro-pince selon l'invention ; et

- la figure 10 représente un schéma d'un embout fixé sur une branche de micro-pince, un doigt de l'embout ayant été préalablement déformé en une position initiale choisie.

Les dessins et la description ci-après contiennent, pour l'essentiel, des éléments de caractère certain. Les dessins représentent, pour partie au moins, des aspects difficiles à décrire autrement que par le dessin. Ils font partie intégrante de la description, et pourront donc non seulement servir à mieux faire comprendre la présente invention, mais aussi contribuer à sa définition, le cas échéant.

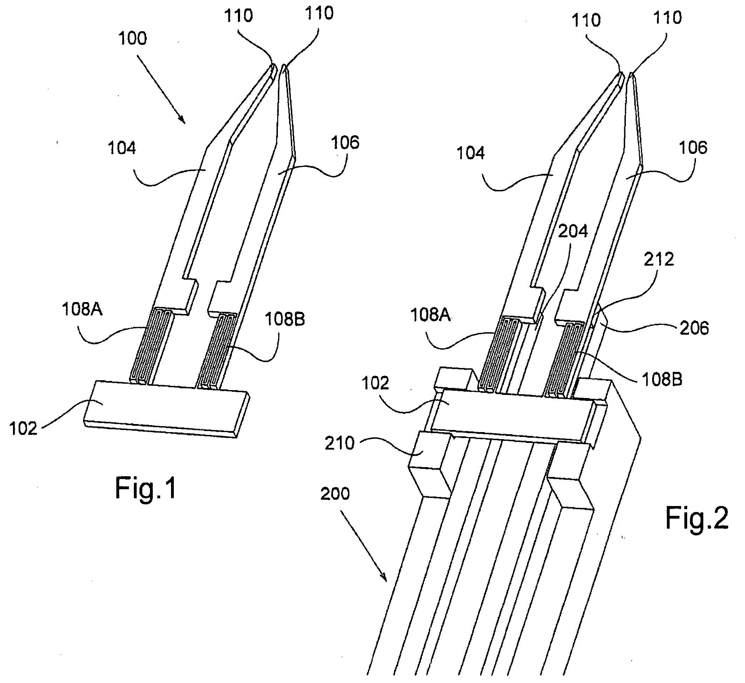

La figure 1 représente une vue schématique en perspective d'un embout selon l'invention. L'embout 100 comprend un support 102 et de premier 104 et deuxième 106 doigts disposés en vis-à-vis l'un par rapport à l'autre en une position choisie. Chaque doigt 104 et 106 est reliée au support 102 par un élément de liaison 108. L'élément de liaison 108 est de faible rigidité et autorise une mobilité selon au moins un degré de liberté de chaque doigt104 et 106 par rapport au support 102.

Dans la présente description et les revendications annexées, les termes « faible rigidité » et « souplesse » (ou « souple ») doivent être considérés comme synonymes. Ces termes définissent une caractéristique autorisant une mobilité d'un élément par rapport à un autre, par déformation mécanique.

L'embout 100 présente un aspect général en forme de pince. La forme de pince résulte de l'ensemble doigts/support, chaque doigt 104 et 106 étant relié au support 102 par un élément de liaison 108. Plus précisément, le premier doigt 104 est relié au support par un premier élément de liaison 108 et le deuxième doigt 106 est relié au support par un deuxième élément de liaison 108. Dans un mode de réalisation préférentiel, chaque doigt 104 et 106 comprend une ou plusieurs griffes 110.

L'embout 100 est conçu pour maintenir un objet entre les griffes 110 lorsque celles-ci sont déplacées l'une vers l'autre (mouvement de pincement).

La figure 1 montre une paire griffes 110 disposées en extrémité distale de chaque doigt 104 et 106 par rapport au support 102. Chaque couple doigt/griffe s'étend en une direction sensiblement opposée par rapport à son équivalent d'en face. En d'autres termes, les deux couples premier doigt 104/griffe 110 et deuxième doigt 106/griffe 110 sont énantiomorphes.

De manière générale, il existe un plan de symétrie entre les griffes 110, voire entre chaque doigt 104 et 106.

La griffe 110 permet de maintenir un objet et de le manipuler de manière sensible. Chaque couple doigt 104 ou 106/griffe 110 présente une forme générale en L.

En considérant le support 102 comme étant fixe, chaque doigt 104 et 106 (avec ou sans griffe 110 est mobile selon au moins un degré de liberté dans l'espace. Cette mobilité est assurée par chaque élément de liaison 108 liant respectivement le premier 104 et le deuxième 106 doigt au support 102.

L'élément de liaison 108 peut être une structure de type ressort pour assurer la souplesse requise. L'élément de liaison 108 peut être réalisé en silicium.

L'élément de liaison 108 peut aussi être réalisé en résine de type résine SU-8. Dans ce mode de réalisation, l'élément de liaison 108 n'est pas nécessairement configuré en structure de type ressort. La souplesse requise est assurée par le matériau de résine SU-8.

L'embout 100 est agencé pour être solidarisé par un ou plusieurs points de fixation sur un micro-actionneur. Chaque point de fixation est réalisé par une pièce dite socle de fixation (voir plus loin).

La figure 2 représente l'embout 100 de la figure 1 montée sur un micro-actionneur. Dans le mode de réalisation de la figure 2, le micro-actionneur 200 comprend deux poutres piézoélectriques déformables 204 et 206. Une extrémité de chaque poutre est encastrée ou apposée de manière fixe à un point d'origine disposé dans/sur un élément de type support ou embase. L'autre extrémité de chaque poutre 204 et 206 est attachée à l'embout 100. Plus précisément, la première poutre 204 est solidarisée au premier doigt 104 par un socle de fixation 404. Respectivement, la deuxième poutre 206 est solidarisée au deuxième doigt 106 par un socle de fixation 406.

Les supports de fixation sur chaque doigt sont disposés au voisinage de l'élément de liaison 108. La solidarisation entre doigts et poutres assure leur déplacement conjoint. Lors d'un déplacement d'une poutre 204 et/ou 206, le doigt 104 et/ou 106 en liaison avec cette poutre est déplacé ensemble avec celle-ci. Le déplacement provient de la déformation de chaque poutre et s'effectue notamment par rapport au support 102. Ainsi on observe une extrémité libre de chaque poutre qui est en mouvement par rapport à l'autre extrémité encastrée ou apposée de manière fixe audit un point d'origine.

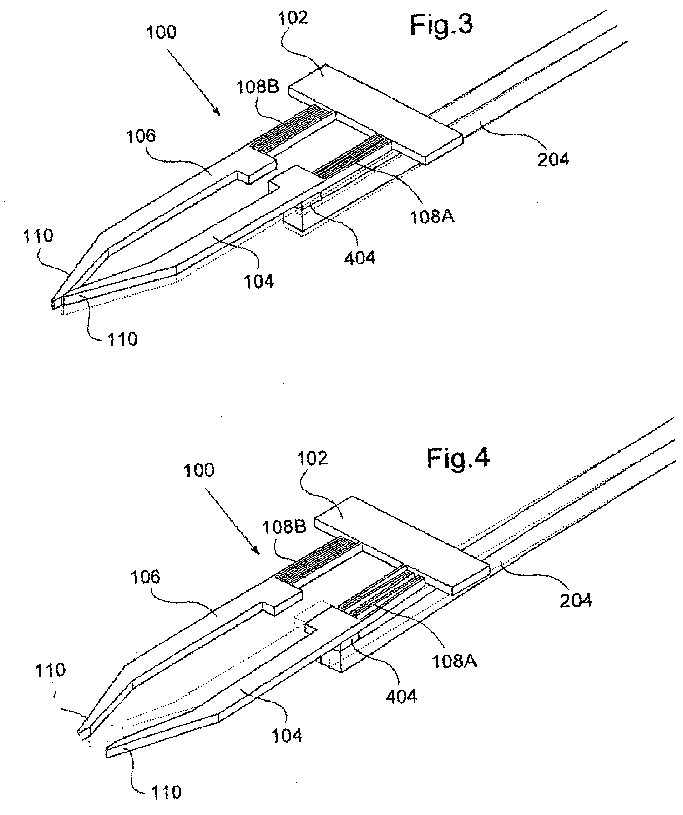

La figure 3 représente un mouvement d'une branche de micro-pince dans un sens vertical. La ligne discontinue (pointillés) représente la position de repos du doigt 104 et de la poutre 204.

La poutre 204 est actionnée et déformée pour soulever le premier doigt 104. De manière plus générale, l'extrémité mobile de la poutre 204 réalise un mouvement vertical et agit sur l'embout 100 qui est attaché solidairement à cette extrémité. La poutre 204 exerce une force sur le doigt 104. L'élément de liaison 108 étant souple, autorise un mouvement vertical du doigt 104 par rapport à l'embase 102. L'élément de liaison 108 absorbe les contraintes. La figure 4 représente un mouvement d'une branche de micro-pince dans un sens horizontal. La ligne discontinue (pointillés) représente la position de repos du doigt 104 et de la poutre 204.

La poutre 204 est actionnée et déformée pour écarter horizontalement le premier doigt 104. De manière plus générale, l'extrémité mobile de la poutre 204 réalise un mouvement horizontal et agit sur l'embout 100 qui est attaché solidairement à cette extrémité. La poutre 204 exerce une force sur le doigt 104. L'élément de liaison 108 étant souple, autorise un mouvement horizontal du doigt 104 par rapport à l'embase 102. L'élément de liaison 108 absorbe les contraintes.

La faible raideur de l'élément de liaison 108 autorise le déplacement selon au moins un degré de liberté de chaque doigt 104 et 106. Chaque doigt 104 ou 106 est déplacé ensemble avec la poutre à laquelle il est relié par son socle de fixation 404 ou 406. Ainsi, il faut prévoir un matériau et une structure de sorte à assurer la mobilité de chaque doigt 104 et 106 par rapport au support 102. L'élément de liaison 108 peut être réalisé en un matériau identique aux autres éléments de l'embout 100 ou être réalisé en un matériau distinct.

De préférence, l'élément de liaison 108 est réalisé de manière à pouvoir définir une position de repos choisie de chaque doigt/griffe. Cette réalisation est généralement assurée soit en utilisant une forme mécanique de faible raideur, soit en utilisant un matériau à faible module d'Young, en regard de la raideur plus importante des autres composants de l'embout 100. Il peut s'agir d'une structure de type ressort en silicium ou encore d'une structure en barre de résine SU-8.

Lorsque l'élément de liaison 108 est réalisé en une structure en barre de résine SU-8, il est avantageux de prévoir son encastrement dans le support 102 et dans le doigt associé 104 ou 106. En effet, le support et les doigts étant réalisés en silicium, il faut prévoir une contraction de matière (*phénomène de retrait*) lors de la cuisson de fabrication. En conséquence un encastrement permet le maintien de l'intégrité de la liaison support/élément de liaison et/ou de la liaison doigt/élément de liaison.

Dans le mode de réalisation des figures 1 à 8, les doigts 104 et 106 s'étendent de manière sensiblement parallèle l'une par rapport à l'autre en position de repos. Chaque axe principal des doigts 104 et 106 est perpendiculaire à l'axe principal longitudinal du support 102. Ceci donne un aspect général en U de l'embout 100, où les branches libres du U représentent les doigts et où la base du U représente le support.

Dans d'autres modes de réalisation la position de repos des doigts peut-être prédéterminée par déformation partielle de l'embout 100 et plus précisément par alternation de l'espacement entre des doigts 104 et 106. Ainsi on peut notamment prévoir un aspect général de l'embout en V ou en Δ.

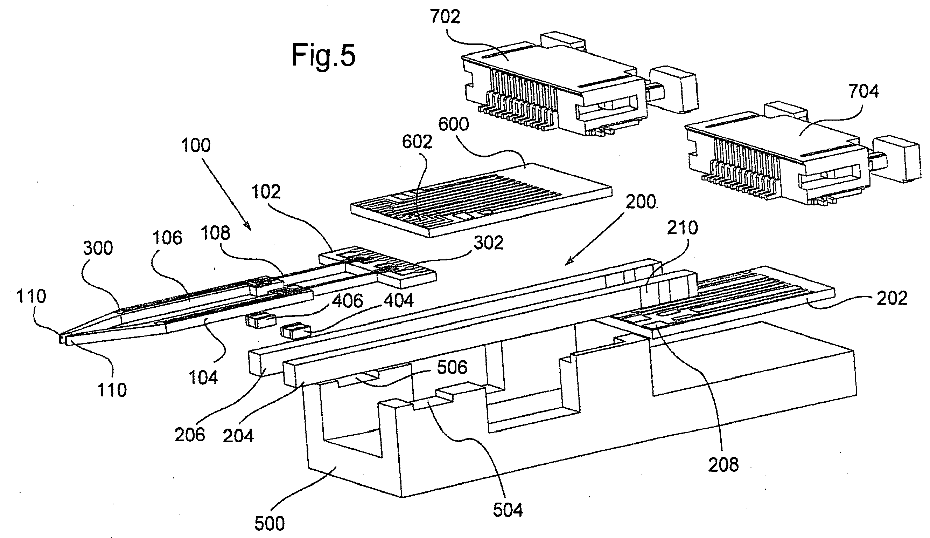

La figure 5 représente une vue éclatée en perspective d'une pince microtechnique de l'invention.

L'embout 100 est prévu pour être monté sur le micro-actionneur 200. Le micro-actionneur 200 comprend des poutres 204 et 206 et un support électronique 202. Le montage de l'embout 100 sur le micro-actionneur 200 est réalisé par l'intermédiaire de socles de fixation 404 et 406.

Plus précisément, le premier doigt 104 est monté sur un socle de fixation 404, lui-même fixé sur la première poutre 204; et respectivement, le deuxième doigt 106 est monté sur un socle de fixation 406, lui-même fixé sur la poutre 206.

Les poutres déformables 204 et 206 du micro-actionneur 200 sont collées sur un support électronique 202. Les poutres 204 et 206 sont reliées électriquement par soudure entre les plots 210 et les pistes électriques 208. Le micro-actionneur 200 comprend un élément piézoélectrique agissant sur au moins une poutre déformable dans l'espace pour permettre un déplacement en translation rapport au support électronique 202. Chaque poutre déformable comprend une extrémité libre mobile dans l'espace. Dans le mode de réalisation de la figure 5 deux poutres 204 et 206 sont prévues.

Les socles de fixation 404 et 406 sont disposés sur le micro-actionneur 200 en une position au voisinage de l'extrémité mobile sur chaque poutre 204 et 206 ; plus généralement les socles de fixation 404 et 406 sont disposés en une position distale par rapport au support électronique 202.

Chaque socle de fixation 404 et 406 est fixé par collage respectivement sur les poutres 204 et 206 et respectivement sur les doigts 104 et 106. Chaque socle de fixation 404 ou 406 possède deux surfaces encollées.

Dans un premier mode de réalisation, les surfaces de contact entre les socles de fixation 404 et 406 et les poutres 204 et 206 sont collées de manière permanente. Les surfaces de contact entre les socles de fixation 404 et 406 et les doigts 104 et 106 sont collées de manière temporaire.

Dans un deuxième mode de réalisation, les surfaces de contact entre les socles de fixation 404 et 406 et les poutres 204 et 206 sont collées de manière temporaire. Les surfaces de contact entre les socles de fixation 404 et 406 et les doigts 104 et 106 sont collées de manière permanente.

Dans les deux modes de réalisation, l'adhésif utilisé pour le collage permanent peut être une colle de type époxy. L'adhésif utilisé pour le collage temporaire peut être de type colle thermique sensible à la chaleur (solide à température ambiante, liquide à température supérieure à 60°C).

Dans le premier mode de réalisation ci-dessus, on peut prévoir que chaque poutre 204 et 206 comprend un circuit chauffant intégré ou adjoint pour élever la température de chaque poutre en vue d'activer ladite colle thermique.

Dans le deuxième mode de réalisation ci-dessus, on peut prévoir que chaque doigt 104 et 106 comprend un circuit chauffant intégré ou adjoint pour élever la température de chaque poutre en vue d'activer ladite colle thermique.

Dans les deux modes de réalisation, les supports de fixations peuvent être des résistances de type CMS (Composants Montés en Surface). En alimentant électriquement lesdites résistances, il est possible d'utiliser l'effet Joule pour élever la température de l'adhésif utilisé pour le collage temporaire.

Les socles de fixation 404 et 406 sont prévus pour assurer une solidarisation entre les doigts 104 et 106 et les poutres 204 et 206 correspondantes du micro-actionneur 200. Sur le micro-actionneur 200, les socles de fixation 404 et 406 sont disposés à l'extrémité libre et mobile de chaque poutre 204 et 206, tandis que sur l'embout 100 les socles de fixation 404 et 406 viennent sur les doigts 104 et 106 au voisinage de l'élément de liaison 108 respectif.

Le support 102 de l'embout 100 est encastré mécaniquement dans les encoches 504 et 506 placées sur la partie supérieure du réceptacle 500. Le micro-actionneur 200 est lui-même encastré mécaniquement au réceptacle 500. L'ensemble micro-actionneur 200, le réceptacle 500 et le support 102 de l'embout 100 forment donc un groupe mécanique fixe.

Les éléments de liaison 108 étant déformables au même titre que les poutres 204 et 206, la liaison mécanique desdites poutres avec respectivement les doigts 204 et 206, par l'intermédiaire des socles de fixation 404 et 406, permet de transmettre la déformation des poutres 204 et 206 aux éléments de liaison 108 respectivement liées aux doigts 104 et 106. Ainsi, lors d'un déplacement de la première poutre 204 et/ou d'un déplacement de la deuxième poutre 206, les doigts 104 et/ou 106 sont déplacés en correspondance, tandis que le support 102 reste statique en une position fixe. L'élément de liaison 108 assure avec sa raideur faible la mobilité des embouts 104 et 106 par rapport au support 102.

L'élément de liaison 108 est choisi avec des caractéristiques de raideur bien définis. Ces caractéristiques dépendent sensiblement du matériau utilisé, mais aussi de la structure et forme de l'élément 108 (type ressort, tige etc.).

De manière générale, l'élément de liaison 108 est choisi avec des caractéristiques de raideur, définissant un compromis entre le besoin de limiter sa flexion sous le poids du doigt associé quelle que soit leur orientation dans l'espace, et la nécessité d'autoriser la mobilité du doigt concerné par rapport au support 102 selon la ou les directions d'actionnement desdites branches de la pince microtechnique.

Dans un mode de réalisation, l'élément de liaison 108 doit être d'une raideur suffisante pour que le poids d'un doigt génère une déformation négligeable (100 μm au maximum) quel que soit l'orientation de l'organe terminal dans l'espace, et l'élément de liaison 108 doit être d'une raideur assez faible pour ne pas entraver le déplacement des branches du micro-actionneur (perte maximale de course 50%), quel que soit le sens de déplacement dudit actionneur.

La conception de la liaison souple des organes terminaux répond à un objectif de maintien en position des doigts avant l'assemblage, et à une contrainte liée à l'effort de rappel de la liaison souple lors du déplacement des doigts.

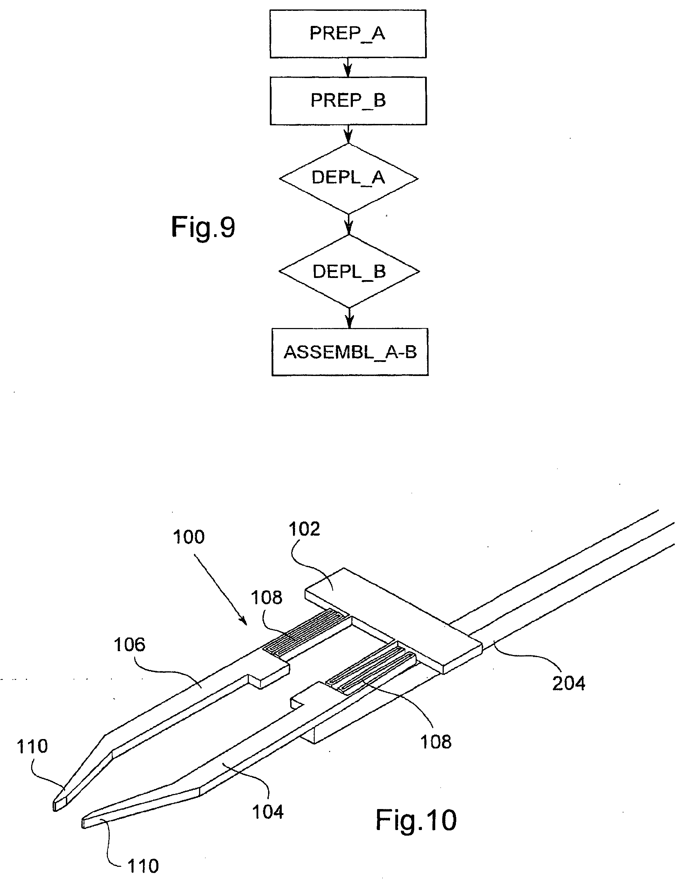

Le maintien en position peut être assuré lorsque les deux doigts sont relativement positionnés de manière connue dans une position initiale choisie (figure 10). Cette connaissance de la position relative des doigts est assurée par la méthode de fabrication monolithique. Soit un repère orthonormé $(O, \vec{x}, \vec{y}, \vec{z})$ permettant de définir 2 vecteurs : $\overrightarrow{P_{fab}}$ et $\overrightarrow{P_{reel}}$.

$\overrightarrow{P_{fab}}$ correspond à la position dans l'espace des deux doigts par rapport à O, connue par construction,

$\overrightarrow{P_{reel}}$ correspond à la position relative réelle des deux doigts par rapport à O.

Il s'y ajoute une matrice K défini la raideur spatiale de la liaison souple (voir ci-dessous).

Parmi les différents phénomènes reliant $\overrightarrow{P_{fab}}$ et $\overrightarrow{P_{reel}}$ (poids, défauts de fabrication, dilatation des matériaux, efforts résiduels, etc.) seul le poids peut être pris en compte. Dans ce cas le paramètre poids intervient seul de manière significative dans le problème de dimensionnement de la liaison souple.

On peut ainsi définir:

$$\overrightarrow{P_{reel}} = \overrightarrow{P_{fab}} - m.\, K \times \vec{g}$$

$$\begin{pmatrix} p_{reel}^x \\ p_{reel}^y \\ p_{reel}^z \end{pmatrix} = \begin{pmatrix} p_{fab}^x \\ p_{fab}^y \\ p_{fab}^z \end{pmatrix} - m.\begin{pmatrix} K_{xx} & K_{xy} & K_{xz} \\ K_{yx} & K_{yy} & K_{yz} \\ K_{zx} & K_{zy} & K_{zz} \end{pmatrix} \times \vec{g}$$

m étant la masse du doigt porté par la liaison souple et g le vecteur gravitation.

On considère que le terme $m.\, K \times \vec{g}$ représente l'essentiel de l'erreur de positionnement entre les deux doigts.

Comme représenté Fig. 1, on considère que la direction principale des embouts est $\vec{x}$ (grande dimension de l'embout), l'axe de déplacement des doigts en ouverture/fermeture $\vec{y}$ et l'axe de déplacement vertical est $\vec{z}$ (il s'agit de directions transversales par rapport à la grande dimension). Dans le cas d'utilisation principal, le vecteur gravité est colinéaire à l'axe $\vec{z}$. Le poids $m.\, g$ sera donc porté sur l'axe $\vec{z}$ et l'erreur de positionnement sera en première approximation défini par K (K étant de type matrice diagonale) :

$$p_{fab}^x - p_{reel}^x = 0$$

$$p_{fab}^{y} - p_{reel}^{y} = 0$$

$$p_{fab}^{z} - p_{reel}^{z} = K_{zz}.m.g$$

Si l'on fixe une erreur maximale de positionnement, il est possible de donner une raideur minimale, permettant de compenser suffisamment le poids du doigt, quel que soit l'orientation de l'organe terminal dans l'espace. Dans le cas d'utilisation principal on a :

$$\text{Min}(K_{zz}) = \frac{\text{Max}(p_{fab}^{z} - p_{reel}^{z})}{m.g}$$

Vu que la pince microtechnique peut être orientée dans n'importe qu'elle direction, il sera considéré que cette raideur minimale devra être respectée dans toutes les directions de l'espace.

$$\text{Min}(K_{xx}) = \text{Min}(K_{yy}) = \text{Min}(K_{zz})$$

Pour un embout tel que représenté Fig. 1, la masse peut être de 10 mg. En considérant une erreur de positionnement admissible de 10 $\mu$m, on obtient une raideur minimale sur z de 10 N/m.

La définition d'une raideur minimale est importante, mais cette raideur possède aussi une borne supérieure. Cette borne supérieure est définie en relation avec la capacité mécanique du micro-actionneur réalisant le déplacement des doigts (branches), après fixation de l'embout sur ledit micro-actionneur.

Les micro-actionneur utilisés pour le déplacement (piézoélectriques, capacitifs, thermiques, magnétiques, etc.) sont caractérisés par une loi faisant intervenir la course maximale de déplacement $\overrightarrow{C_{max}}$, une entrée de commande $\vec{U}$ et une force d'actionnement $\vec{F}$

$$\overrightarrow{C_{max}} = f(\vec{U}, \vec{F})$$

En simplifiant la loi de comportement de l'actionneur utilisé, il est possible d'écrire :

$$\overrightarrow{C_{max}} = A.\vec{U} - B.\vec{F}$$

A et B étant des matrices de paramètres du modèle linéarisé du micro-actionneur utilisé. Les matrices sont considérées diagonales pour des raisons de simplification.

$$A = \begin{pmatrix} a_x & 0 & 0 \\ 0 & a_y & 0 \\ 0 & 0 & a_z \end{pmatrix} ; B = \begin{pmatrix} b_x & 0 & 0 \\ 0 & b_y & 0 \\ 0 & 0 & b_z \end{pmatrix}$$

Dans le cas de poutres piézoélectriques multicouches (notamment tel que décrit dans FR2845026), le déplacement maximal pour 11 volts est de 50 $\mu$m sur l'axe $\vec{y}$ pour une force nulle. À déplacement nul, pour la même tension, la force est de 40 mN. On peut alors identifier les paramètres sur le même axe :

$$a_y = \frac{C_{max}^{y}}{U_y} = 4,55.10^{-6}$$

$$b_y = a_y \frac{U_y}{F_y} = 1{,}25 . 10^{-3}$$

Comme le micro-actionneur va déformer l'élément souple 108 pour déplacer un doigt, la loi intègre la force de rappel de l'élément souple 108. Cette loi est dépendante des caractéristiques de raideur de l'élément souple 108. Il vient alors :

$$\overrightarrow{C_{max}^{chargée}} = A.\vec{U} - B.(\vec{F} - K \times \overrightarrow{C_{max}^{chargée}})$$

Il est ainsi possible de définir, en fonction des paramètres a et b du micro-actionneur utilisé, une raideur maximale pour laquelle la perte de déplacement induite par l'élément souple est fixée.

Dans le cas d'une poutre piézoélectrique multicouche, si l'on souhaite garder une course égale à 95% de la course libre sur l'axe $\vec{y}$, on a :

$$C_y^{chargée} = 0{,}95 \times C_{max}^y$$

$$C_y^{chargée} = a_y U_y - b_y(-\text{Max}(K_{yy}).C_y^{chargée})$$

$$\text{Max}(K_{yy}) = \frac{C_y^{chargée} - a_y U_y}{b_y C_y^{chargée}}$$

Ainsi, pour le cas de la poutre piézoélectrique présenté ci-dessus, on obtient

$$\text{Max}(K_{yy}) = 42\text{N/m}$$

Ce calcul de bornes inférieures et supérieures permet d'optimiser le dimensionnement de la raideur de l'élément souple afin de garantir le positionnement des doigts, tout en limitant la perte d'actionnement induite par cette liaison souple 108.

Dans le mode de réalisation décrit sur la figure 5, le micro-actionneur 200 est de type piézoélectrique. En variante, des micro-actionneurs du type sensibles aux effets électrostatiques, thermiques ou capacitifs sont envisageables.

Dans un mode de réalisation, chaque poutre 204 et 206 est déformable dans l'espace selon au moins un degré de liberté.

Dans un mode de réalisation préférentiel, chaque poutre 204 et 206 est de type piézoélectrique multicouche comprenant deux jeux d'électrodes. Le premier jeu d'électrode procure la déformation de la poutre correspondante dans une première direction (par exemple une direction verticale), tandis que le deuxième jeu d'électrode procure la déformation de cette poutre dans une deuxième direction (par exemple une direction horizontale).

Ainsi, dans le mode de réalisation décrit ici, le déplacement de chaque poutre 204 et 206 se fait selon deux degrés de liberté à partir d'une position de repos. Il s'agit en principe de deux degrés de liberté en translation dans deux directions sensiblement perpendiculaires. Toutefois, un déplacement plus complexe à deux degrés de liberté ou plus reste envisageable, par exemple un mouvement d'extension/rétraction/torsion. La figure 3 représente la poutre 204 en un état contraint et déformée verticalement. En conséquence, l'élément de liaison 108 est contraint et déformé verticalement. La figure 4 représente la poutre 204 en un état contraint et déformée horizontalement. En conséquence, l'élément de liaison 108 est contraint et déformé horizontalement. Selon un mode de réalisation de l'invention, le micro-actionneur 200 offre une course totale des poutres 204 et 206 d'environ 200 μm sur un premier axe et une course totale d'environ 200 μm sur un deuxième axe. En d'autres termes la course relative haut/bas (sens +/-) est respectivement d'environ

100 μm sur un premier axe à partir de la position de repos ; et la course relative droite/gauche (sens +/-) est respectivement d'environ 100 μm sur un deuxième axe à partir de la position de repos.

Le micro-actionneur 200 est en connexion électrique avec le support électronique 202 qui est reliée à une embase de soutient 704. Les poutres 204 et 206 du micro-actionneur 200 peuvent être logées dans un réceptacle 500. Le réceptacle 500 est conformé sensiblement en U et comprend deux parois extérieures respectivement marquées par une encoche 504 et 506. Plus précisément, le réceptacle est conformée selon une forme en tube rectangulaire sectionnée dans le sens de la longueur, dont la largeur peut varier. Chaque encoche 504 et 506 est disposée sur les bords libres du réceptacle 500. Chaque encoche 504 et 506 est conformée pour recevoir une partie du support 102 de l'organe terminal 100. La figure 5 montre un capteur 300 disposé sur chaque griffe 110. Le capteur peut être monté à un autre un endroit choisi sur chaque doigt. L'intégration du capteur 300 peut se faire au moment de la fabrication de l'embout 100, de manière monolithique. Le capteur 300. peut aussi être installé par assemblage sur les doigts ou griffes.

Afin d'extraire l'information du capteur 300, il faut que celui-ci soit connecté électriquement à un dispositif d'analyse. La connectique électrique entre le capteur 300 et un dispositif d'analyse est généralement difficile à mettre en place. Le mode de réalisation de la figure 5 montre les bornes électriques 302 disposées sur le support 102 de l'embout 100. Les bornes électriques 302 du capteur 300 sont disposées sur le support 102 de l'embout 100. La connectique électrique entre les bornes électriques 302 vers un dispositif d'analyse est assurée par l'intermédiaire d'une plaque de transmission 600 comprenant des connexions électriques 602 agencées pour être reliées aux bornes électriques 302. Le connecteur 702 permet la liaison électrique vers le dispositif d'analyse.

Le capteur 300 peut être un capteur d'effort, une jauge de contrainte, un capteur de température, un capteur de pression, un capteur d'hygrométrie, un capteur de contact ou tout autre type de capteur nécessaire pour réaliser une micromanipulation.

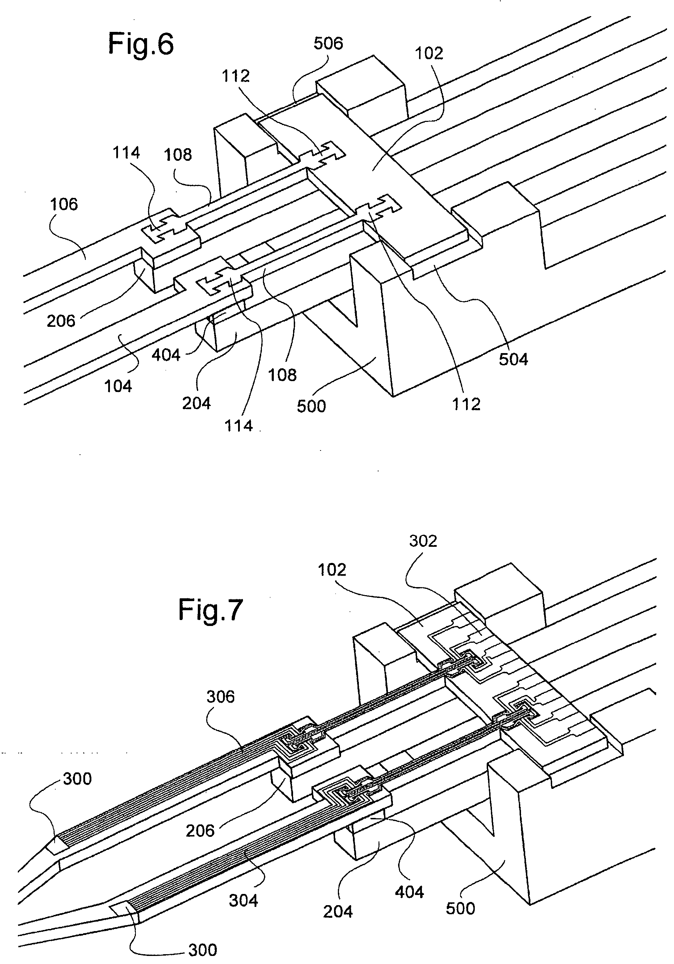

La figure 6 montre un embout 100 de l'invention disposé sur un réceptacle 500. Le support 102 est positionné dans les encoches 504 et 506 du réceptacle 500. La forme en correspondance entre les encoches 504 et 506 d'une part et le support 102 d'autre part, permet le maintien en position statique dudit support 102. La figure 6 montre un détail de la figure 5 et particulièrement un élément de liaison 108 réalisé en résine SU-8. Une première extrémité de l'élément de liaison 108 est encastrée dans le support 102 par une portion sur support 112. Une deuxième extrémité de l'élément de liaison 108 est encastrée dans un doigt 104 ou 106 par la portion sur doigt 114.

Dans cette configuration, l'élément de liaison 108 peut généralement comprendre un nombre de pistes électroniques supérieur au mode de réalisation avec une structure de type ressort.

La figure 7 montre un embout 100 comprenant un capteur 300. Des pistes électriques 304 assurent la connexion électrique entre le capteur 300 et les bornes électriques 302 sur le support 102 de l'embout 100.

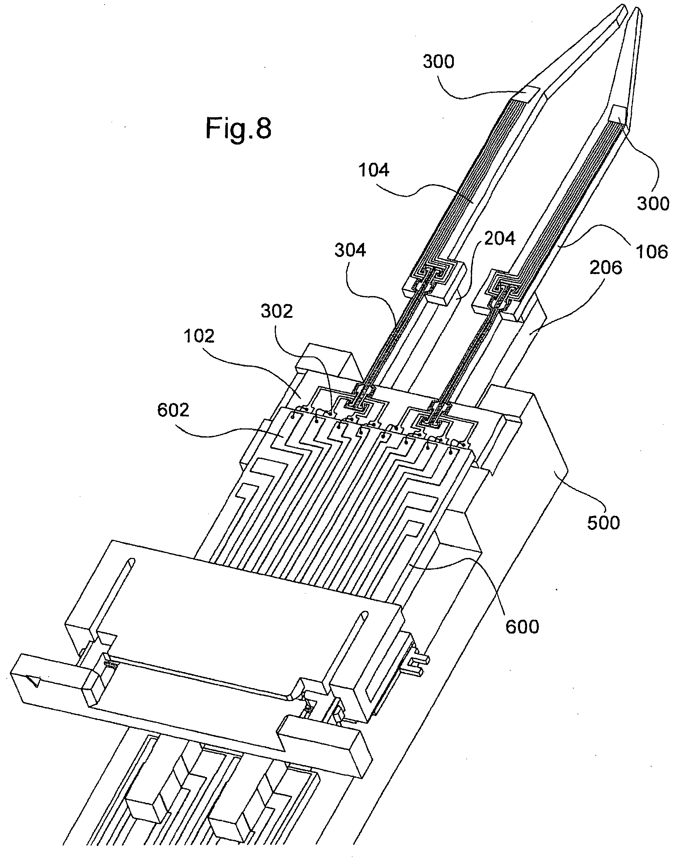

La figure 8 représente une vue en perspective d'un outil pour pince microtechnique comprenant un embout 100 combiné avec une plaque de transmission 600. L'embout 100 comprend et un capteur d'effort 300 reliés électriquement vers des bornes électriques 302 disposées sur le support 102.

La présente invention vise également un kit microtechnique pour le montage d'une pince microtechnique telle que décrite ci-dessus. Le kit peut notamment comprendre un outil pour pince microtechnique un embout 100, un micro-actionneur 200 comprenant de première 204 et deuxième 206 poutres déplaçables, et un réceptacle 500 étant conformé sensiblement en U et comprenant deux parois extérieures marquées par une ou plusieurs encoches 504 et/ou 506 conformées pour recevoir ledit support 102 de l'embout 100 de l'outil pour pince microtechnique.

Dans ce kit, l'embout 100 peut être muni d'un capteur 300. Le kit peut également contenir des ustensiles de montage, comme par exemple de la colle thermique pour fixer les doigts104 et 106 respectivement sur les poutres 204 et 206.

Il faut comprendre que la présente invention peut se présenter sous différentes formes de conception pour sa commercialisation. Certaines pièces peuvent être pré-assemblées en usine. Ceci dépend de l'usage, l'application et de l'éventuelle détérioration des pièces. À titre d'exemple on peut citer la combinaison entre un embout 100 et une plaque de transmission 600 ou la combinaison du micro-actionneur 200 avec une plaque de connectique électrique 700 et un réceptacle 500.

l'embout 100 est susceptible de constituer une pièce dite « jetable » ou « échangeable ». Un remplacement ou échange de cet embout 100 peut être prévu après détérioration des griffes 110 ou encore si l'application change (par exemple lorsqu'il est utile de manipuler avec des griffes 110 particulières).

Le remplacement de l'embout 100 est simplifié pour l'utilisateur si l'embout 100 est fourni ensemble avec la plaque de transmission 600 comme le montre la figure 8. Les deux pièces peuvent être pré-assemblés en usine et ainsi faciliter, le cas échéant, la maintenance de la pince microtechnique lors d'un remplacement ou échange.

L'invention vise en outre un procédé de montage d'une pince microtechnique.

La figure 9 montre les différentes opérations dudit procédé de montage.

Une première opération PREP_A comprend la préparation d'un outil pour pince microtechnique avec la mise à disposition d'un un embout 100. Une deuxième étape PREP_B comprend la préparation d'un micro-actionneur 200 comprenant de première 204 et deuxième 206 poutres déplaçables.

L'opération suivante DEPL_A est optionnelle et consiste en une manipulation d'au moins un des doigts 104 et/ou 106 de manière à modifier leur position de repos avant de solidariser lors d'une opération terminale d'assemblage. L'élément de liaison 108 pouvant être réalisé d'une raideur faible (souple), il est alors possible par application de forces de type torsion, flexion, traction ou autre, de déplacer les doigts l'un par rapport à l'autre.

Un embout 100 peut avoir des doigts 104 et 106 sensiblement parallèles, ce qui lui confère un aspect général en U.

Les doigts 104 et 106 peuvent être notamment écartés l'un par rapport à l'autre. L'embout 100 présente alors un aspect général en V. La figure 10 illustre ce mode de montage. L'élément de liaison 108 est déformé au repos, puis l'embout 100 est apposé sur les poutres. Après déformation, chaque doigt est en une position dite position initiale comme le montre la figure 10.

Les doigts 104 et 106 peuvent être notamment rapprochés l'un par rapport à l'autre. L'embout 100 présente alors un aspect général en Δ.

Une autre opération DEPL_B optionnelle consiste en un déplacement des première 204 et deuxième 206 poutres du micro-actionneur 200 en une position choisie avant l'opération terminale d'assemblage.

Les opérations optionnelles DEPL_A et DEPL_B peuvent être réalisés au choix l'une après l'autre ou en même temps, dès lors qu'elles interviennent toutes les deux avant fixation de l'embout 100 sur le micro-actionneur 200.

Les opérations optionnelles DEPL_A et DEPL_B permettent soit d'agencer les poutres 204 et 206 en une position prédéterminée (DEPL_B), soit de modifier la position de repos des doigts 104 et 106 (DEPL_A). Ainsi, chaque doigt peut être fixé sur la poutre respective en une position de repos choisie en vue d'une sensibilité d'échelle de précision de manipulation voulue. En effet, une fois que la pince microtechnique est assemblée c'est l'écartement en position de repos des doigts 104 et 106 qui définit la distance de course. Celle-ci peut donc être prédéfinie lors de l'une des opérations optionnelles DEPL_A et DEPL_B. En conséquence l'invention fournit une pince microtechnique dont les capacités de manipulation couvre des tailles d'objets pouvant aller de 10 $\mu$m à 2000 $\mu$m. L'invention comble donc le vide existant de l'état de la technique, offrant une pince capable de manipuler des objets de 10 à 2000 $\mu$m avec un précision comprise entre 1 et 10 $\mu$m.

Une opération terminale ASSEMBL_A-B comprend la solidarisation par un point de fixation (par voie de collage par socle de fixation) des premier 104 et deuxième 106 doigt de l'outil pour pince microtechnique respectivement sur les première 204 et deuxième 206 poutres du micro-actionneur 200 de ladite pince microtechnique.

Par solidarisation on entend dans la présente description un assemblage suffisamment solide entre une poutre et un doigt pour permettre le déplacement dudit doigt lorsque la poutre est actionnée. En aucun cas il faut entendre par là une structure statique ou fixée des pièces de la pince microtechnique. La fonction de pinçage doit être assurée.

Lors de l'opération terminale ASSEMBL_A-B il est prévu de loger lesdits premier104 et deuxième 106 doigts et lesdites première 204 et deuxième 206 poutres dans un réceptacle 500. Le réceptacle 500 est de préférence conformé sensiblement en U (tube rectangulaire sectionné en sens de la longueur - voir figure 5 notamment). Le réceptacle 500 comprend deux parois extérieures marquées par au moins une encoche 504 et/ou 506 qui est conformée pour recevoir le support 102 de l'organe terminal 100 de l'outil pour pince microtechnique. L' l'opération terminale ASSEMBL_A-B peut donc comprendre le positionnement du support 102 dans chaque encoche 504 et/ou 506. Le collage des supports de fixation est réalisé avec un adhésif de type colle thermique sensible à la chaleur. Dans ce mode de réalisation on peut prévoir le positionnement initial de colle au choix, soit en une position distale sur chaque sur chaque poutre 204 et 206, soit en une position au voisinage de l'élément de liaison 108 sur chaque doigt 104 et 106. Dans ce mode de réalisation, les poutres 204 et 206 comprennent un circuit chauffant intégré ou adjoint pour élever la température de chaque poutre en vue d'activer ladite colle thermique.

**Revendications**

1. Outil pour pince microtechnique, comprenant un embout (100) comportant:

   - un support (102) et
   - un premier doigt (104) et un deuxième doigt (106),

   chaque doigt possédant un socle de fixation (404, 406) par lequel il est destiné à être fixé sur une branche (204, 206) de micro-actionneur (200) pour positionner les doigts côte à côte en des positions initiales respectives, définies par rapport à au moins une direction d'actionnement des branches de la pince microtechnique,
   et chaque doigt (104, 106) étant relié audit support (102) par un élément de liaison respectif (108A, 108B) souple agencé de manière à maintenir le doigt en une position de repos correspondant à sa position initiale, cet élément de liaison (108) étant choisi avec des caractéristiques de raideur, définissant un compromis entre le besoin de limiter la flexion de l'élément de liaison (108) sous le poids du doigt associé quelle que soit l'orientation du doigt dans l'espace, et la nécessité d'autoriser la mobilité du doigt concerné par rapport au support (102) selon la ou les directions d'actionnement desdites branches de la pince microtechnique.

2. Outil pour pince microtechnique selon la revendication 1, dans lequel l'élément de liaison (108) présente une grande dimension qui s'étend sensiblement dans le prolongement du doigt respectif et les caractéristiques de raideur sont définies par rapport à une direction généralement transversale à ladite grande dimension.

3. Outil pour pince microtechnique selon l'une des revendications précédentes, dans lequel chaque doigt comprend une griffe (110) disposée en extrémité distale par rapport au support (102).

4. Outil pour pince microtechnique selon l'une des revendications précédentes, dans lequel l'élément de liaison (108) est réalisé en résine photosensible de type SU-8.

5. Outil pour pince microtechnique selon l'une des revendications précédentes, dans lequel l'embout (100) est réalisé monolithiquement et dans lequel l'élément de liaison (108) comprend une structure ressort.

6. Outil pour pince microtechnique selon l'une des revendications précédentes, comprenant en outre au moins un capteur (300) disposé sur au moins un desdits doigts (104, 106), le capteur étant préférentiellement choisi parmi le groupe constitué d'un capteur d'effort, d'un capteur de température, d'un capteur de pression, d'un capteur d'hygrométrie et d'un capteur de contact.

7. Outil pour pince microtechnique selon l'une des revendications précédentes, comprenant en outre une plaque de transmission (600) reliée électriquement sur le support (102) de l'embout (100).

8. Pince microtechnique comprenant un outil selon l'une des revendications 1 à 7, et un micro-actionneur (200) comprenant de première (204) et deuxième (206) branches déplaçables, chaque branche étant solidarisée par un socle de fixation (404, 406) respectivement avec le premier doigt (104) et le deuxième doigt (106).

9. Pince microtechnique selon la revendication 8, dans lequel un réceptacle (500) loge les branches (204, 206) déplaçables, le réceptacle (500) étant conformé sensiblement en U et comprenant deux parois extérieures marquées chacune par une encoche (504, 506) conformée pour recevoir ledit support (102) de l'embout (100).

10. Pince microtechnique selon l'une des revendication 8 et 9, dans laquelle chaque doigt (104, 106) dudit embout (100) est muni d'un capteur (300) dont les bornes électriques (302) sont disposées sur le support (102), et dans laquelle une plaque de transmission (600) de signaux comprenant des connexions électriques est disposée en contact avec ledit support pour relier électriquement lesdites bornes électriques (302) avec lesdites connexions électriques (602).

11. Pince microtechnique selon l'une des revendications 8 à 10, dans laquelle le micro-actionneur (200) est choisi parmi le groupe constitué d'un micro-actionneur thermique, d'un micro-actionneur piézo-électrique et d'un micro-actionneur électrostatique.

12. Kit microtechnique pour le montage d'une pince microtechnique comprenant :

   - un outil pour pince microtechnique selon l'une des revendications 1 à 7,
   - un micro-actionneur (200) comprenant de première (204) et deuxième (206) branches déplaçables,
   - un réceptacle (500) étant conformé sensiblement en U et comprenant deux parois extérieures chacune marquées par une encoche (504, 506) conformée pour recevoir ledit support (102) de l'embout (100) de l'outil pour pince microtechnique.

13. Kit microtechnique selon la revendication 12, dans lequel un capteur (300) disposé sur au moins un des doigts (104, 106) de l'embout (100) dont les bornes électriques (302) sont disposées sur ledit support (102), ledit kit comprenant en outre :

   - une plaque de transmission (600) de signaux comprenant des connexions électriques (602), agencée pour être disposée en contact avec ledit support (102) pour relier électriquement lesdites bornes électriques (302) avec lesdites connexions électriques (602).

**14.** Procédé de montage d'une pince microtechnique comprenant les étapes suivantes :

a. préparer (PREP_A) un outil pour pince microtechnique selon l'une des revendications 1 à 7,
b. préparer (PREP_B) un micro-actionneur (200) comprenant de première (204) et deuxième (206) branches déplaçables, et
c. solidariser (ASSEMBL_A-B) par un socle de fixation (404, 406) les premier (104) et deuxième (106) doigts de l'embout (100) pour pince microtechnique respectivement avec les première (204) et deuxième (206) poutres du micro-actionneur (200) pour former ladite pince microtechnique.

**15.** Procédé selon la revendication 14, comprenant en outre l'étape suivante :

c1. déplacer (DEPL_B) lesdites première (204) et deuxième (206) poutres du micro-actionneur (200) en une position choisie avant de solidariser à l'étape c.

**16.** Procédé selon l'une des revendications 14 à 15, comprenant en outre l'étape suivante :

c2. manipuler (DEPL_A) chaque doigt par application d'une force de manière à modifier leur position de repos avant de solidariser à l'étape c.

**17.** Procédé selon l'une des revendications 14 à 16, comprenant en outre les étapes suivantes :

d. loger lesdits premier (104) et deuxième (106) doigts et lesdites première (204) et deuxième (206) poutres dans un réceptacle (500) conformé sensiblement en U et comprenant deux parois extérieures marquées par au moins une encoche (504, 506) conformée pour recevoir le support (102) de l'embout (100) de l'outil pour pince microtechnique, et
e. positionner ledit support (102) dans chaque encoche (504, 506).


**Patentansprüche**

**1.** Werkzeug für eine mikrotechnische Klammer, mit einem Ansatz (100), aufweisend:

- einen Träger (102), und
- einen ersten Finger (104) und einen zweiten Finger (106), wobei jeder Finger einen Befestigungssockel (404, 406) besitzt, mittels dem er dazu bestimmt ist, an einem Schenkel (204, 206) eines Mikrostellglieds (200) befestigt zu werden, um die Finger benachbart in jeweiligen Ausgangspositionen zu positionieren, die in Bezug auf mindestens eine Betätigungsrichtung der Schenkel der mikrotechnischen Klammer vorgegeben sind,

und wobei jeder Finger (104, 106) mit dem Träger (102) mittels eines jeweiligen nachgiebigen Verbindungselements (108A, 108B) verbunden ist, das so eingerichtet ist, dass es den Finger in einer Ruheposition hält, die seiner Ausgangsposition entspricht, wobei dieses Verbindungselement (108) mit Steifigkeitseigenschaften ausgewählt ist, die einen Kompromiss vorgeben zwischen der Bedingung, die Durchbiegung des Verbindungselements (108) unter dem Gewicht des zugeordneten Fingers, wie auch immer die Ausrichtung des Fingers im Raum sein mag, einzuschränken, und der Notwendigkeit, die Beweglichkeit des betreffenden Fingers in Bezug auf den Träger (102) entsprechend der oder den Betätigungsrichtung/en der Schenkel der mikrotechnischen Klammer zuzulassen.

**2.** Werkzeug für eine mikrotechnische Klammer nach Anspruch 1, wobei das Verbindungselement (108) eine große Abmessung aufweist, die sich im Wesentlichen in der Verlängerung des jeweiligen Fingers erstreckt, und die Steifigkeitseigenschaften in Bezug auf eine zur großen Abmessung allgemein quer verlaufenden Richtung vorgegeben sind.

**3.** Werkzeug für eine mikrotechnische Klammer nach einem der vorhergehenden Ansprüche, wobei jeder Finger eine Kralle (110) aufweist, die in Bezug auf den Träger (102) am distalen Ende angeordnet ist.

**4.** Werkzeug für eine mikrotechnische Klammer nach einem der vorhergehenden Ansprüche, wobei das Verbindungselement (108) aus lichtempfindlichem Harz des Typs SU-8 hergestellt ist.

**5.** Werkzeug für eine mikrotechnische Klammer nach einem der vorhergehenden Ansprüche, wobei der Ansatz (100) monolithisch hergestellt ist, und wobei das Verbindungselement (108) eine Federstruktur aufweist.

6. Werkzeug für eine mikrotechnische Klammer nach einem der vorhergehenden Ansprüche, darüber hinaus mindestens einen Sensor (300) aufweisend, der auf zumindest einem der Finger (104, 106) angeordnet ist, wobei der Sensor vorzugsweise aus der Gruppe ausgewählt ist, die aus einem Kraftsensor, einem Temperatursensor, einem Drucksensor, einem Feuchtigkeitssensor und einem Berührungssensor besteht.

7. Werkzeug für eine mikrotechnische Klammer nach einem der vorhergehenden Ansprüche, darüber hinaus eine Übertragungsplatte (600) aufweisend, die auf dem Träger (102) des Ansatzes (100) elektrisch angeschlossen ist.

8. Mikrotechnische Klammer mit einem Werkzeug nach einem der Ansprüche 1 bis 7 und einem Mikrostellglied (200), das einen ersten (204) und einen zweiten (206) Schenkel aufweist, die verlagerbar sind, wobei jeder Schenkel mittels eines Befestigungssockels (404, 406) mit dem ersten Finger (104) bzw. dem zweiten Finger (106) fest verbunden ist.

9. Mikrotechnische Klammer nach Anspruch 8, wobei eine Aufnahme (500) die verlagerbaren Schenkel (204, 206) aufnimmt, wobei die Aufnahme (500) im Wesentlichen zu einem U geformt ist und zwei Außenwände aufweist, die jeweils mittels einer Ausklinkung (504, 506) markiert sind, die zur Aufnahme des Trägers (102) des Ansatzes (100) geformt ist.

10. Mikrotechnische Klammer nach einem der Ansprüche 8 und 9, wobei jeder Finger (104, 106) des Ansatzes (100) mit einem Sensor (300) versehen ist, dessen elektrische Anschlusselemente (302) auf dem Träger (102) angeordnet sind, und wobei eine Signalübertragungsplatte (600) mit elektrischen Anschlüssen in Kontakt mit dem Träger angeordnet ist, um die elektrischen Anschlusselemente (302) elektrisch mit den elektrischen Anschlüssen (602) zu verbinden.

11. Mikrotechnische Klammer nach einem der Ansprüche 8 bis 10, wobei das Mikrostellglied (200) aus der Gruppe ausgewählt ist, die aus einem thermischen Mikrostellglied, einem piezoelektrischen Mikrostellglied und einem elektrostatischen Mikrostellglied besteht.

12. Mikrotechnischer Bausatz zur Montage einer mikrotechnischen Klammer, aufweisend:

   - ein Werkzeug für eine mikrotechnische Klammer nach einem der Ansprüche 1 bis 7,
   - ein Mikrostellglied (200) mit einem ersten (204) und einem zweiten (206) Schenkel, die verlagerbar sind,
   - eine Aufnahme (500), die im Wesentlichen zu einem U geformt ist und zwei Außenwände aufweist, die jeweils mittels einer Ausklinkung (504, 506) markiert sind, die zur Aufnahme der Trägers (102) des Ansatzes (100) des Werkzeugs für eine mikrotechnische Klammer geformt ist.

13. Mikrotechnischer Bausatz nach Anspruch 12, wobei ein Sensor (300) auf zumindest einem der Finger (104, 106) des Ansatzes (100) angeordnet ist, dessen elektrische Anschlusselemente (302) auf dem Träger (102) angeordnet sind, wobei der Bausatz darüber hinaus aufweist:

   - eine Signalübertragungsplatte (600) mit elektrischen Anschlüssen (602), die dazu eingerichtet sind, in Kontakt mit dem Träger (102) angeordnet zu werden, um die elektrischen Anschlusselemente (302) elektrisch mit den elektrischen Anschlüssen (602) zu verbinden.

14. Verfahren zur Montage einer mikrotechnischen Klammer, die folgenden Schritte umfassend:

   a. Vorbereiten (PREP_A) eines Werkzeugs für eine mikrotechnische Klammer nach einem der Ansprüche 1 bis 7,
   b. Vorbereiten (PREP_B) eines Mikrostellglieds (200) mit einem ersten (204) und einem zweiten (206) Schenkel, die verlagerbar sind, und
   c. festes Verbinden (ASSEMBL_A-B), und zwar mittels eines Befestigungssockels (404, 406), des ersten (104) und zweiten (106) Fingers des Ansatzes (100) für eine mikrotechnische Klammer mit einem ersten (204) bzw. zweiten (206) Balken des Mikrostellglieds (200), um die mikrotechnische Klammer zu bilden.

15. Verfahren nach Anspruch 14, darüber hinaus den folgenden Schritt umfassend:

   c1. Verlagern (DEPL_B) des ersten (204) und zweiten (206) Balkens des Mikrostellglieds (200) in eine ausgewählte Position, und zwar vor dem festen Verbinden im Schritt c.

16. Verfahren nach einem der Ansprüche 14 bis 15, darüber hinaus den folgenden Schritt umfassend:

c2. Beeinflussen (DEPL_A) jedes Fingers durch Anwenden einer Kraft, um deren Ruheposition zu verändern, und zwar vor dem festen Verbinden im Schritt c.

17. Verfahren nach einem der Ansprüche 14 bis 16, darüber hinaus die folgenden Schritte umfassend:

d. Einbringen des ersten (104) und zweiten (106) Fingers und des ersten (204) und zweiten (206) Balkens in eine Aufnahme (500), die im Wesentlichen zu einem U geformt ist und zwei Außenwände aufweist, die mittels mindestens einer Ausklinkung (504, 506) markiert sind, die zur Aufnahme des Trägers (102) des Ansatzes (100) des Werkzeugs für eine mikrotechnische Klammer geformt ist, und
e. Positionieren des Trägers (102) in jeder Ausklinkung (504, 506).

## Claims

1. Tool for a microtechnical gripper, comprising a tip (100) having:

   - a support (102) and
   - a first finger (104) and a second finger (106),

   each finger having a fixing base (404, 406) by which it is to be fixed to a microactuator (200) arm (204, 206) in order to position the fingers side by side in respective starting positions, which are defined relative to at least one direction of actuation of the arms of the microtechnical gripper,
   and each finger (104, 106) being connected to said support (102) by a respective flexible connecting element (108A, 108B) which is arranged so as to maintain the finger in a rest position corresponding to its starting position, the connecting element (108) being chosen with stiffness properties that define a compromise between the need to limit the deflection of the connecting element (108) under the weight of the associated finger, whatever the orientation of the finger in space, and the necessity of allowing the finger in question to move relative to the support (102) in the direction or directions of actuation of said arms of the microtechnical gripper.

2. Tool for a microtechnical gripper according to claim 1, wherein the connecting element (108) has a large dimension which extends substantially as a continuation of the respective finger, and the stiffness properties are defined relative to a direction generally transverse to said large dimension.

3. Tool for a microtechnical gripper according to any one of the preceding claims, wherein each finger comprises a claw (110) disposed at the distal end relative to the support (102).

4. Tool for a microtechnical gripper according to any one of the preceding claims, wherein the connecting element (108) is made of photosensitive resin of type SU-8.

5. Tool for a microtechnical gripper according to any one of the preceding claims, wherein the tip (100) is produced monolithically and wherein the connecting element (108) comprises a spring structure.

6. Tool for a microtechnical gripper according to any one of the preceding claims, further comprising at least one sensor (300) disposed on at least one of said fingers (104, 106), the sensor preferably being selected from the group consisting of a force sensor, a temperature sensor, a pressure sensor, a humidity sensor and a contact sensor.

7. Tool for a microtechnical gripper according to any one of the preceding claims, further comprising a transmission plate (600) connected electrically to the support (102) of the tip (100).

8. Microtechnical gripper comprising a tool according to any one of claims 1 to 7 and a microactuator (200) having first (204) and second (206) displaceable arms, each arm being attached by a fixing base (404, 406) to the first finger (104) and the second finger (106), respectively.

9. Microtechnical gripper according to claim 8, wherein a receiver (500) houses the displaceable arms (204, 206), the receiver (500) being substantially U-shaped and having two outside walls each marked with a recess (504, 506) configured to receive said support (102) of the tip (100).

10. Microtechnical gripper according to either claim 8 or claim 9, wherein each finger (104, 106) of said tip (100) is provided with a sensor (300), the electrical terminals (302) of which are disposed on the support (102), and wherein a signal transmission plate (600) having electrical connections is disposed in contact with said support in order electrically to connect said electrical terminals (302) to said electrical connections (602).

11. Microtechnical gripper according to any one of claims 8 to 10, wherein the microactuator (200) is chosen from the group consisting of a thermal microactuator, a piezoelectric microactuator and an electrostatic microactuator.

12. Microtechnical kit for the mounting of a microtechnical gripper, comprising:

- a tool for a microtechnical gripper according to any one of claims 1 to 7,
- a microactuator (200) having first (204) and second (206) displaceable arms,
- a receiver (500) being substantially U-shaped and having two outside walls each marked with a recess (504, 506) configured to receive said support (102) of the tip (100) of the tool for a microtechnical gripper.

13. Microtechnical kit according to claim 12, wherein a sensor (300) disposed on at least one of the fingers (104, 106) of the tip (100), the electrical terminals (302) of which are disposed on said support (102), said kit further comprising:

- a signal transmission plate (600) which has electrical connections (602) and is arranged to be disposed in contact with said support (102) in order electrically to connect said electrical terminals (302) to said electrical connections (602).

14. Process for mounting a microtechnical gripper, comprising the following steps:

a. preparing (PREP_A) a tool for a microtechnical gripper according to any one of claims 1 to 7,
b. preparing (PREP_B) a microactuator (200) having first (204) and second (206) displaceable arms, and
c. attaching (ASSEMBL_A-B), by means of a fixing base (404, 406), the first (104) and second (106) fingers of the tip (100) for a microtechnical gripper to the first (204) and second (206) beams, respectively, of the microactuator (200) to form said microtechnical gripper.

15. Process according to claim 14, further comprising the following step:

c1. displacing (DEPL_B) said first (204) and second (206) beams of the microactuator (200) into a chosen position prior to the attachment in step c.

16. Process according to either claim 14 or claim 15, further comprising the following step:

c2. manipulating (DEPL_A) each finger by application of a force so as to modify their rest positions prior to the attachment in step c.

17. Process according to any one of claims 14 to 16, further comprising the following steps:

d. housing said first (104) and second (106) fingers and said first (204) and second (206) beams in a receiver (500) which is substantially U-shaped and has two outside walls marked by at least one recess (504, 506) configured to receive the support (102) of the tip (100) of the tool for a microtechnical gripper, and
e. positioning said support (102) in each recess (504, 506).

Fig.2

Fig.1

Fig.3

Fig.4

Fig.5

## Fig.6

Fig.8

Fig.9

Fig.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 20060181097 A1
- US 4666198 A
- US 5046773 A
- WO 2004028756 A
- DE 10114551
- FR 2845026